# FASCICULE DE BREVET EUROPEEN

(11) **EP 3 645 460 B1**
(45) Date de publication et mention de la délivrance du brevet: **10.01.2024**
(21) Numéro de dépôt: 18737692.6
(22) Date de dépôt: 20.06.2018
(51) Int. Cl.: C01B 32/162, C01B 32/164, D01F 9/127, D01F 9/133, H01B 1/04

(54) **PROCEDE DE FABRICATION DE NANOTUBES DE CARBONE FIXES SUR UN SUBSTRAT**
VERFAHREN ZUR HERSTELLUNG VON AN EINEM SUBSTRAT BEFESTIGTEN KOHLENSTOFFNANORÖHRCHEN
METHOD FOR PRODUCING CARBON NANOTUBES ATTACHED TO A SUBSTRATE

(30) Priorité: 26.06.2017 FR 1755818
(43) Date de publication de la demande: 06.05.2020
(73) Titulaire: Nawatechnologies, 13100 Aix-En-Provence (FR)
(72) Inventeur: BOULANGER, Pascal, 13510 Eguilles (FR); GOISLARD DE MONSABERT, Thomas, 83470 Saint-Maximin-la-Sainte-Baume (FR)
(74) Mandataire: Schmidt, Martin Peter
(86) Numéro de dépôt international: PCT/FR2018/051474
(87) Numéro de publication internationale: WO 2019/002721

(56) Documents cités:
- EP-B1- 1 515 911
- WO-A1-2014/202740
- WO-A2-2005/098084
- WO-A2-2006/137852
- WO-A2-2007/009112
- US-A1- 2008 206 463

## Description

### Domaine technique de l'invention

L'invention concerne le domaine des nanotubes en carbone, et concerne plus particulièrement un nouveau procédé pour la fabrication de nanotubes de carbone par décomposition catalytique d'un composé précurseur de carbone. Cette synthèse se fait sur un substrat poreux qui est traversé par un flux de gaz apportant de manière continue un précurseur de catalyseur se déposant sur ce substrat.

### Etat de la technique

On connaît de nombreuses méthodes pour déposer des nanotubes ou nanofibres de carbone. La plupart procèdent par décomposition catalytique d'un gaz précurseur de carbone sur un substrat. Le catalyseur peut être apporté par le substrat (où il a été déposé préalablement), ou par la phase gazeuse. La croissance est toujours limitée par la désactivation progressive du catalyseur. On connaît de plusieurs types de réacteur pour la croissance de nanotubes ou nanofibres de carbone, par exemple celui décrit dans WO 2014/202740 A1.

Il est bien connue de l'homme du métier que la croissance de nanotubes de carbone sur un substrat catalytique est limitée (voir par exemple : « Carbon Nanotube Synthesis and Growth Mechanism », Chapter 8, par M. Kumar, DOI: 10.5772/19331, http://www.intechopen.com).

L'article de Kumar présente les deux modèles de croissance le plus souvent utilisés pour des nanotubes de carbone. Ces deux modèles partent du dépôt d'une particule de catalyseur sur un substrat. Dans le premier modèle appelé « tip-growth model » cette particule interagit faiblement avec le substrat, et la croissance du nanotube procède par du carbone généré par décomposition catalytique d'un gaz hydrocarbure au-dessus de la particule, le carbone diffusant vers la base de la particule et formant au-dessous de la particule le nanotube de carbone qui soulève ladite particule ; cependant, la particule catalytique se désactive progressivement par la formation d'une nappe de carbone sur sa partie supérieure ou par perte progressive de matière. Dans le deuxième modèle appelé « base growth model » la particule interagit fortement avec le substrat, et la croissance du nanotube procède par du carbone généré par décomposition catalytique d'un gaz hydrocarbure à la base de la particule, le carbone diffusant vers le sommet de la particule et formant au-dessus de la particule le nanotube de carbone ; cependant, la particule catalytique se désactive progressivement par perte de réactivité chimique ou par perte progressive de matière.

On connaît également les nanotubes verticalement alignés (VACNT). Les VACNT sont constitués de nanotubes de carbone dont le diamètre est compris entre quelques namomètres et quelques dizaines de nanomètres. Le procédé de synthèse des VACNT consiste en une décomposition catalytique hétérogène de précurseurs gazeux au niveau de particules catalytiques (CVD catalytique) qui sont localisées à l'interface entre le substrat et la base des nanotubes de carbone (« base growth mechanism »). La longueur (épaisseur du tapis) atteint typiquement quelques centaines de micromètres, mais peut atteindre jusqu'à plusieurs millimètres ; la longueur des nanotubes est limitée par deux phénomènes : La désactivation ou la désagrégation progressive des particules catalytique au cours du procédé de synthèse des nanotubes, et l'augmentation progressive de la résistance à la diffusion des précurseurs gazeux vers la base des nanotubes et à l'évacuation des sous-produits de réaction vers le sommet des nanotubes. En réalité on observe le plus souvent une décroissance logarithmique de la croissance des nanotubes verticalement alignés avec le temps (voir par exemple : Jourdain et Bichara, Carbon 58 (2013) p.2-39).

Il a été démontré que la première de ces deux difficultés peut être contournée en introduisant le catalyseur de manière continue dans le réacteur : le document EP 1 515 911 décrit un procédé dans lequel on introduit dans le réacteur un précurseur de catalyseur sous la forme d'un aérosol, par injection périodique tout au long de la durée de la synthèse des nanotubes ; ce procédé permet d'obtenir des nanotubes de carbone verticalement alignés qui se déposent sur un substrat chauffé ou sur les parois intérieures du réacteur. Dans ce procédé le catalyseur est renouvelé régulièrement. En pratique, la longueur des nanotubes que l'on peut obtenir par ce procédé est cependant limitée par la diffusion des précurseurs gazeux et des sous-produits gazeux : on ne dépasse pas une longueur d'environ un millimètre. Cela suffit pour de nombreuses applications, mais on souhaiterait pouvoir produire des nanotubes plus longs fixés sur un substrat.

Le problème que la présente invention cherche à résoudre est donc de présenter un nouveau procédé permettant de fabriquer des nanofibres ou nanotubes de longueur importante (de préférence au moins centimétrique), fixés sur un substrat, et de préférence alignés perpendiculairement à ce substrat.

### Objets de l'invention

Le procédé selon l'invention comprend le dépôt des nanotubes de carbone par décomposition catalytique d'un précurseur de carbone. Selon l'invention, on alimente en permanence et simultanément la zone réactionnelle en nanoparticules catalytiques et en précurseur de carbone. Cela permet de s'affranchir d'un premier problème des procédés de dépôt de nanotubes ou nanofibres de carbone connus, à savoir de la disparition ou désactivation du catalyseur : le catalyseur devenu inactif ou ayant disparu par désagrégation (c'est-à-dire ayant été progressivement entraîné dans le corps des nanotubes au cours de leur croissance) est remplacé tout au long du procédé.

Selon l'invention, on approvisionne le précurseur de carbone directement au voisinage des particules catalytiques, ou plus précisément au voisinage de la zone du substrat dans laquelle se déposent lesdites particules catalytiques. Cela permet de s'affranchir d'un deuxième problème des procédés de dépôt de nanotubes ou nanofibres de carbone connus, à savoir l'arrêt progressif de la croissance des nanotubes par blocage de la diffusion des précurseurs et des produits secondaires. En particulier, on choisit une configuration dans laquelle le flux des réactifs (particules de précurseur de catalyseur et précurseur de carbone) n'est plus opposé au flux des sous-produits. Cette configuration de flux est réalisée à l'aide d'un substrat poreux dans lequel ou sur lequel on dépose les particules catalytiques.

Selon l'invention le problème est donc résolu par un procédé qui réunit plusieurs moyens :
Le premier moyen est un substrat poreux qui est mis en contact avec les particules de catalyseur. Le deuxième moyen est l'apport d'un premier flux gazeux comportant un catalyseur ou un composé précurseur d'un catalyseur. Le composé source de carbone peut être apporté par ce premier flux gazeux et/ou par un deuxième flux gazeux ; ce deuxième flux gazeux peut être spatialement séparé dudit premier flux gazeux. Le troisième moyen est l'apport de ce premier flux gazeux, et si présent, dudit deuxième flux gazeux à proximité dudit substrat poreux. Le quatrième moyen est le dépôt du catalyseur dans ledit substrat poreux ou sur une surface dudit substrat poreux ou encore à proximité dudit substrat poreux, et la décomposition catalytique du composé source de carbone sur ce catalyseur déposé.

Dans un mode de réalisation avantageux, on confine la zone réactionnelle, c'est-à-dire la zone où a lieu la décomposition catalytique du composé source de carbone, à la zone où se déposent les particules catalytiques. Ce confinement peut être réalisé de différentes manières. On peut chauffer le substrat poreux et approvisionner au moins un des gaz réactifs, ou tous les gaz réactifs, de manière localisée. On peut également chauffer le substrat poreux de manière localisée. Dans un mode de réalisation on combine ces deux moyens, à savoir l'approvisionnement localisé en gaz réactif(s) et le chauffage localisé.

Un premier objet de l'invention est un procédé de préparation de nanotubes, nanofibres ou nanofilaments de carbone par décomposition d'au moins un précurseur de carbone en présence d'un catalyseur, dans lequel procédé, de manière continue :
- un premier flux gazeux comprenant un précurseur d'un catalyseur est mis en contact avec un substrat poreux ;
- un deuxième flux gazeux comportant au moins un précurseur de carbone est mis en contact avec ledit substrat poreux ;
- ledit substrat poreux est chauffé à une température conduisant au dépôt de particules de catalyseur et à la croissance catalytique de nanotubes de carbone. Cette température se situe de préférence entre 500 °C et 1 000 °C.

Ledit premier flux gazeux, et si présent, ledit deuxième flux gazeux, sont apportés à proximité dudit substrat poreux.

Avantageusement, ledit substrat poreux est traversé au moins en partie par ledit premier flux gazeux, et/ou ledit premier flux gazeux est dirigé sur une zone de surface dudit substrat poreux. Ledit premier flux gazeux et ledit deuxième flux gazeux peuvent être représentés par le même flux de mélange gazeux. Ledit substrat poreux est chauffé de manière localisée dans la zone par laquelle ledit premier flux gazeux quitte le substrat, ou dans la zone sur laquelle est dirigé ledit premier flux gazeux. Le chauffage localisé peut se faire par induction. Chacune de ces caractéristiques permet d'assurer le confinement de la zone réactionnelle où se déposent les particules de catalyseur.

Ledit précurseur de carbone peut être un hydrocarbure ou peut comprendre un hydrocarbure ; cet hydrocarbure est de préférence l'acétylène. On peut aussi utiliser du monoxyde de carbone.

Dans un mode de réalisation avantageux ledit premier flux gazeux est généré à partir d'un aérosol comportant un composé métallo-organique dans un gaz vecteur. Ledit aérosol peut être généré par injection périodique d'une phase liquide comprenant ledit composé métallo-organique dans un gaz vecteur.

Ledit composé métallo-organique peut être sélectionné dans le groupe formé par le ferrocène, le cobaltocène, le nickélocène.

Ledit substrat poreux est avantageusement sélectionné dans le groupe formé par: le silicium poreux, l'alumine poreuse, le carbure de silicium poreux, les mousses métalliques présentant des pores interconnectées, les mousses de carbone présentant des pores interconnectées, les nanotubes de carbone verticalement alignés, les substrats mixtes comportant plusieurs de substrat précédents. Il peut être une membrane poreuse.

Un autre objet de l'invention est un réacteur pour la mise en oeuvre du procédé selon l'invention, comportant, dans le sens de l'écoulement du flux de gaz :
o Une zone d'injection d'un flux de gaz réactif pourvue de premiers moyens de chauffage aptes à chauffer les gaz à une température T2 comprise entre 250 °C et 450 °C,
o Un substrat poreux parcouru par ledit flux de gaz réactif,
o Une zone pourvue de deuxièmes moyens de chauffage aptes à chauffer au moins une partie dudit substrat poreux à une température T3 comprise entre 450 °C et 700 °C,
o Une zone tubulaire de déploiement apte à permettre le déploiement des nanofibres ou nanotubes formées,
o Une sortie par laquelle les gaz peuvent quitter ledit réacteur.

Le réacteur comprend, de préférence dans ladite zone de déploiement, des troisièmes moyens de chauffage aptes à chauffer les nanotubes ou nanofibres formées à une température T4 comprise entre 800 °C et 2 000 °C. Cela peut améliorer la cristallinité des nanofibres ou nanotubes formés.

Le réacteur peut comprendre des moyens d'approvisionnement d'un premier flux de gaz réactif comprenant un précurseur d'un catalyseur et d'un deuxième flux de gaz réactif comprenant au moins un précurseur de carbone. Lesdits moyens d'approvisionnement d'un premier et deuxième flux de gaz réactif peuvent comprendre un réservoir pour chacun des premier et deuxième gaz réactif.

Le réacteur peut comprendre des moyens de confinement de la zone de décomposition catalytique du précurseur de carbone.

Le réacteur peut encore comprendre des moyens pour recueillir lesdites nanofibres ou nanotubes.

Lesdits deuxièmes moyens de chauffage sont de préférence des moyens de chauffage localisé, c'est-à-dire des moyens aptes à chauffer de manière localisée au moins une partie dudit substrat poreux. Par conséquent, lors du fonctionnement du réacteur, avantageusement ladite au moins une partie du substrat poreux se trouve, par l'effet chauffant desdits moyens de chauffage localisé, à une température supérieure à celle du flux de gaz réactif qui entre dans ledit substrat poreux. Ces moyens de chauffage localisé peuvent agir comme des moyens de confinement de la zone de décomposition catalytique du précurseur de carbone.

### Figures

Les figures 1 à 6 illustrent différents aspects de l'invention.
Les figures 1 et 2 montrent de manière schématique le principe du procédé selon l'invention.
La figure 3 montre de manière schématique deux moyens de confinement du chauffage à proximité de la surface de sortie du substrat poreux. La figure 4 montre de manière schématique deux variantes du dispositif selon l'invention. La figure 5 montre de manière schématique deux variantes du procédé selon l'invention.
La figure 6 montre de manière schématique trois modes de réalisation de l'invention avec une buse à injection coaxiale.

### Description

La présente invention présente plusieurs caractéristiques essentielles, et d'autres caractéristiques qui ne sont qu'optionnelles.

Selon l'invention on utilise un procédé de dépôt chimique en phase vapeur à partir d'un ou plusieurs composés hydrocarbures agissant comme précurseurs de carbone (appelé ici aussi « source de carbone »), ledit dépôt chimique en phase vapeur étant catalysé par des particules catalytiques. Lesdites particules catalytiques sont déposées sur le substrat poreux, ou formées sur ledit substrat poreux. Elles proviennent d'un composé précurseur d'un catalyseur qui est apporté par un premier flux gazeux ; cela représente une première caractéristique essentielle de l'invention. Dans un mode de réalisation avantageux ledit composé précurseur d'un catalyseur est introduit dans ledit premier flux gazeux sous la forme de particules liquides ou solides finement divisées ; autrement dit ledit premier flux gazeux comprend au moins dans une partie de son parcours un aérosol (appelé ici aussi « aérosol catalyseur »). L'introduction du composé précurseur de catalyseur sous la forme d'un aérosol comportant des particules solides et/ou liquides dudit composé précurseur de catalyseur représente un mode de réalisation très préféré du procédé selon l'invention. Dans d'autres modes de réalisation ledit composé précurseur d'un catalyseur est introduit dans le premier flux gazeux sous forme gazeuse.

Selon une autre caractéristique essentielle de l'invention les gaz réactifs sont mis en contact avec un substrat poreux. Le terme « gaz réactif » désigne ici le premier flux gazeux, c'est-à-dire d'une part, l'aérosol catalyseur et la phase gazeuse qui résulte de l'évaporation et/ou décomposition, partielle ou totale, desdites particules lors de leur transport vers ledit substrat poreux, et, d'autre part, le (ou les) composé(s) source de carbone, éventuellement dans leur gaz porteur, sachant que le (ou les) composé(s) source de carbone peuvent faire partie dudit premier flux gazeux, et/ou peuvent faire partie d'un deuxième flux gazeux. La mise en contact des gaz réactifs avec le substrat poreux peut se faire dans un flux commun ou dans des flux séparés, par exemple un premier flux issu de l'aérosol catalyseur et un deuxième flux comportant le composé source de carbone. Il est entendu que le précurseur de catalyseur peut être également une source de carbone, c'est-à-dire la partie organique de la molécule organo-métallique peut servir, après décomposition de la molécule, comme source de carbone, et/ou le solvant de ladite molécule organo-métallique, si un solvant est utilisé, peut servir comme source de carbone.

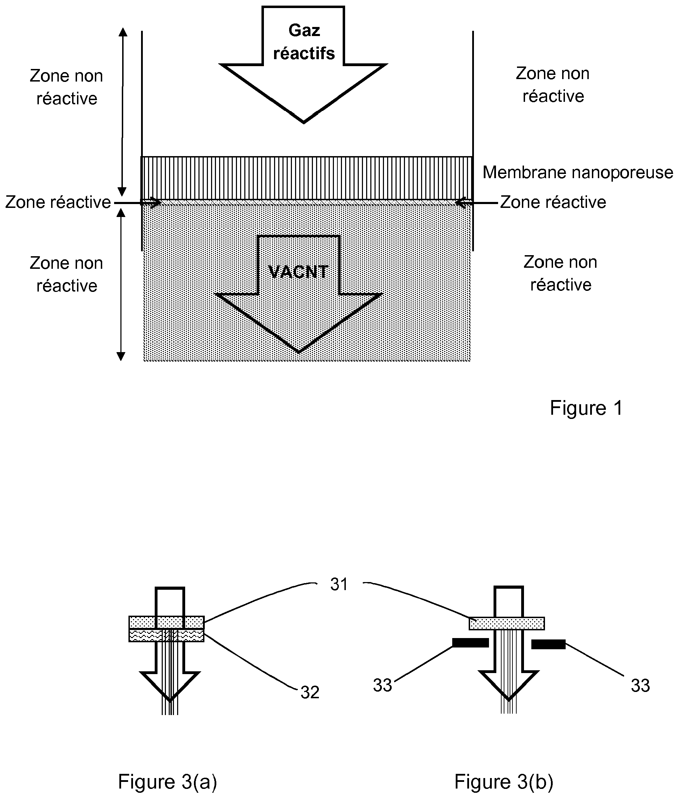

Dans un mode de réalisation illustré schématiquement sur la figure 1, le substrat poreux est une membrane, et elle est traversée par un flux de gaz réactif. Cela entraîne le confinement spatial du flux de gaz réactif. Cette membrane peut notamment être microporeuse, méso-poreuse et/ou nanoporeuse.

Selon une autre caractéristique essentielle de l'invention on apporte de l'énergie aux gaz réactifs afin de permettre la croissance de nanotubes ou nanofibres de carbone. Cet apport d'énergie peut se faire dans une zone confinée. Dans un mode de réalisation illustré schématiquement sur la figure 1 ce confinement se fait dans une zone proche de la surface de la membrane nanoporeuse. Ainsi, les réactions chimiques conduisant à la croissance des nantotubes ou nanofibres se déroulent dans une zone confinée.

Selon une autre caractéristique essentielle de l'invention on apporte le flux de gaz réactifs de manière continue, permettant la croissance ininterrompue de nanotubes ou nanofils. Dans le mode de réalisation illustré schématiquement sur la figure 1 cette croissance conduit à un tapis de VANCT de grande longueur, formant un faisceau.

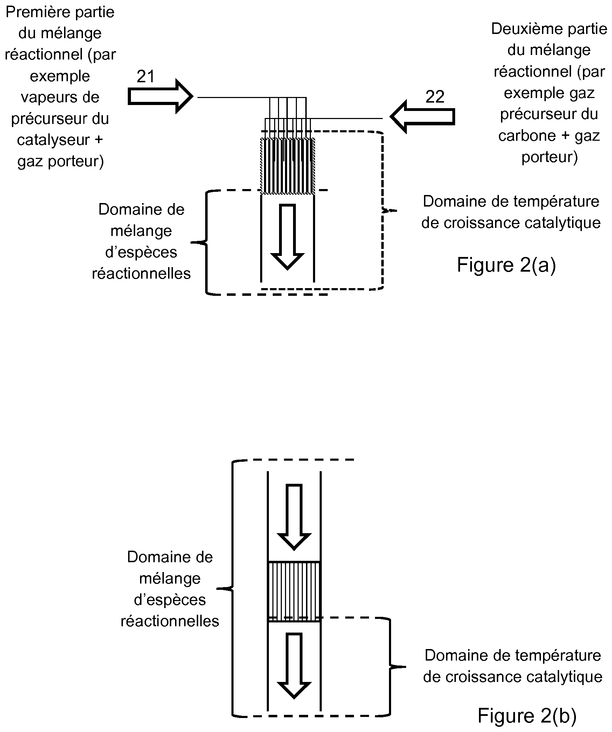

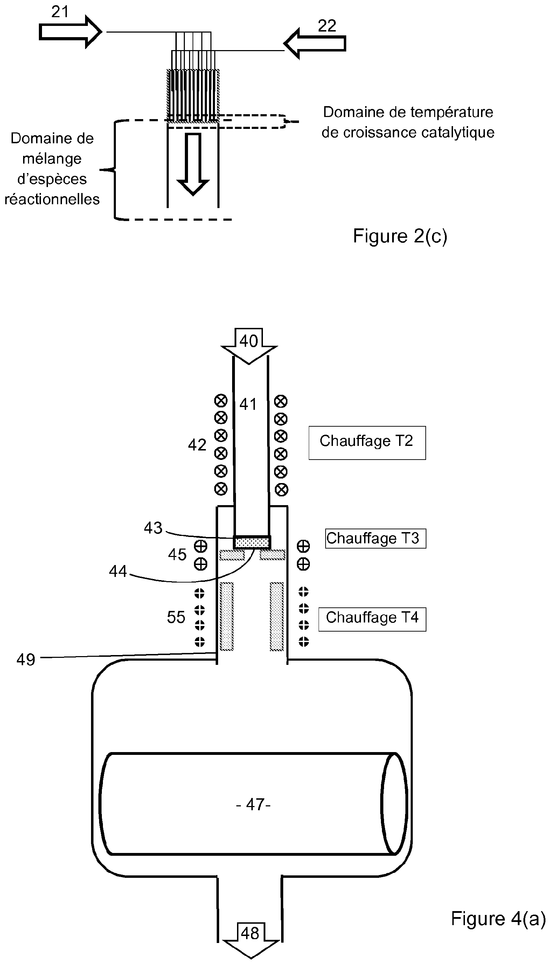

La figure 2 illustre de manière schématique le rôle du confinement de l'apport énergétique. La figure 2(a) montre un substrat poreux traversé par un premier flux gazeux **21** et par un deuxième flux gazeux **22**; ces deux flux gazeux se mélangent au sein d'une zone confinée du substrat, dans une enceinte chauffée. Le mode de chauffage du substrat ne génère pas de confinement du chauffage au sein du substrat. La figure 2(b) montre un substrat poreux traversé par un flux gazeux unique avec un apport d'énergie thermique localisé en aval du substrat poreux qui ne chauffe le substrat que dans une zone de faible épaisseur proche de sa sortie. La figure 2(c) montre la même configuration, mais avec un apport d'énergie confiné dans une zone de faible épaisseur proche de la sortie du substrat poreux.

La figure 3 montre de manière schématique deux modes de réalisation pour réaliser un chauffage localisé du substrat par induction : avec une mousse métallique fixée en sortie du substrat poreux (figure 4(a)) et avec un anneau métallique en sortie du substrat poreux (figure 3(b)).

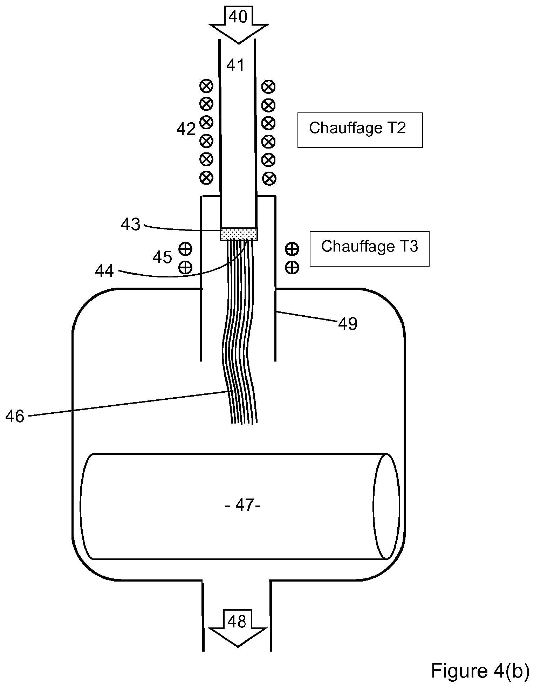

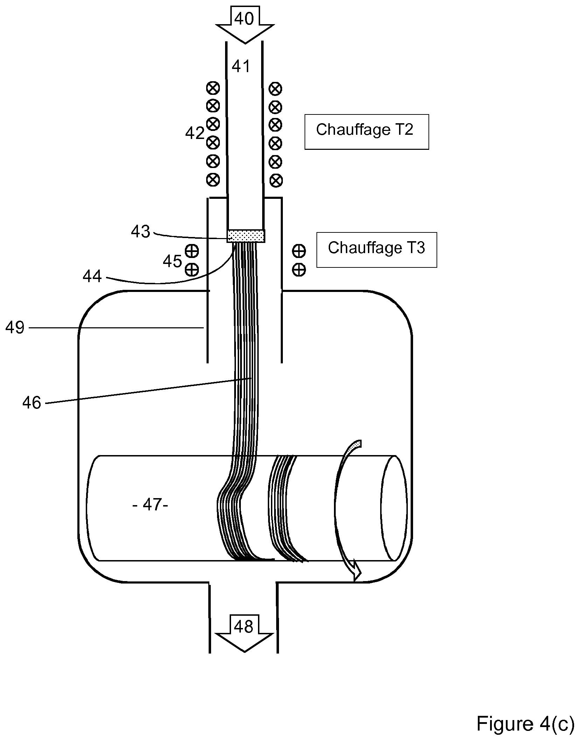

La figure 4 monte de manière schématique quatre vues partielles en section transversale de réacteurs qui conviennent pour la mise en oeuvre de l'invention.

### 1. Les réactifs

Le premier flux gazeux comprend initialement l'aérosol catalyseur, qui comprend des particules comprenant un composé de métal précurseur d'un catalyseur, lesdites particules étant véhiculées par un gaz vecteur. Ce gaz vecteur peut comprendre un composé hydrocarbure précurseur de carbone, ou il peut être inerte dans les conditions de réaction choisies (il peut s'agir par exemple d'un composé hydrocarbure qui ne se décompose pas catalytiquement dans les conditions réactionnelles choisies, ou il peut s'agir d'azote ou d'hydrogène). Lesdites particules comprenant un composé de métal précurseur d'un catalyseur peuvent être produites à partir d'un liquide (à la température T1 à laquelle se trouve ledit liquide au moment où il est acheminé dans le dispositif de formation d'aérosol) qui est constitué par ledit composé de métal précurseur d'un catalyseur, si ce composé est un liquide, ou par une solution dudit composé de métal précurseur d'un catalyseur dans un solvant liquide. Ledit solvant liquide peut être un composé hydrocarbure précurseur de carbone, ou il peut être un composé qui n'est pas décomposé dans les conditions réactionnelles de décomposition catalytique sur le substrat poreux. Avantageusement l'aérosol catalyseur comprend initialement des particules liquides. L'aérosol catalyseur peut être formé par injection périodique d'une phase liquide (se trouvant à la température T1) dans un gaz vecteur. On peut utiliser une pompe à injection de type courant tel qu'elle est utilisé dans les moteurs à explosion.

Lors de leur acheminement vers le substrat poreux ces particules liquides (la température dans cette zone du réacteur étant nommée ici T2) peuvent s'évaporer partiellement ou totalement ; en particulier, leur solvant peut s'évaporer partiellement ou totalement, et la particule formant l'aérosol catalyseur peut devenir une particule solide constituée du composé de métal précurseur d'un catalyseur, ou peut s'évaporer. Lors de leur acheminement vers le substrat poreux ces particules liquides ou solides ou ces molécules gazeuses (la température dans cette zone du réacteur étant nommée ici T3) peuvent se décomposer partiellement ou totalement, notamment par pyrolyse, libérant ainsi le catalyseur métallique qu'ils contiennent. Les détails de la décomposition des particules formant l'aérosol catalyseur ou des molécules gazeuses de précurseur catalytique, et de la formation de particules catalyseur sur le substrat poreux ou dans le substrat poreux ne sont pas connus des inventeurs, et ils ne souhaitent pas être liés par les représentations théoriques qu'ils se font de cette partie du procédé selon l'invention.

Ledit composé hydrocarbure précurseur de carbone peut être apporté par ledit premier flux de gaz (où il peut agir comme gaz vecteur de l'aérosol), et/ou il peut être apporté par d'autres flux de gaz (par exemple par ledit deuxième flux de gaz, et/ou un troisième flux de gaz). Ledit composé hydrocarbure précurseur de carbone peut être introduit lui aussi, au sous la forme d'un aérosol comprenant des particules liquides finement divisées comprenant un composé hydrocarbure précurseur de carbone (appelé ici par la suite « aérosol hydrocarbure »); dans ce dernier cas l'aérosol hydrocarbure peut être apporté dans le même flux que l'aérosol catalyseur, ou par un autre flux.

En tout état de cause le composé précurseur de carbone peut comprendre un seul composé ou plusieurs composés. Il s'agit de préférence d'hydrocarbures, mais il peut également contenir par exemple du monoxyde de carbone (CO).

Dans un mode de réalisation, le composé précurseur d'un métal catalyseur est le ferrocène. Le ferrocène présentant un point de fusion de l'ordre de 172 °C et un point d'évaporation de l'ordre de 250°C, il convient de le dissoudre, de préférence dans le toluène. L'aérosol catalyseur comprend donc des gouttelettes de toluène dans lesquelles est dissous le ferrocène. La température T1 peut être comprise par exemple entre 0 °C et 50 °C, et avantageusement entre 15 °C et 30 °C. Lorsque le toluène s'évapore (point d'ébullition environ 110 °C) le ferrocène reste dans l'aérosol catalyseur sous la forme de particules solides ou liquides, ou le mélange devient un mélange puremennt gazeux, selon la température T2 de la zone du réacteur. A titre d'exemple T2 peut être comprise entre 120 °C et 450 °C et de préférence entre 250 C et 450 °C. On peut utiliser d'autres solvants, tels que le benzène ou le xylène.

On sait que le ferrocène présente un point d'ébullition (ou évaporation) de l'ordre 250 °C ; les inventeurs ne pensent pas que la structure exacte des particules du précurseur de catalyseur dans l'aérosol catalyseur soit importante pour la présente invention ; selon la conduite du procédé, et notamment en fonction des températures T1 et T2 il est donc possible que l'aérosol catalyseur change de structure entre le moment où on injecte les particules de précurseur de catalyseur dans le gaz vecteur du premier flux gazeux et le moment où ce flux gazeux arrive sur la surface du solide poreux dans la zone à la température T3. On sait que le ferrocène se décompose vers 450 °C en fer et cyclopentane, et dans un mode de réalisation avantageux la température T3 est au moins égale à 450 °C. A titre d'exemple T3 peut être compris entre 450 °C et 700 °C. Cette décomposition du ferrocène peut se faire dans le premier flux gazeux et/ou en contact avec le substrat poreux. Selon un aspect essentiel de l'invention le catalyseur se dépose ou se forme dans le substrat poreux ou sur le substrat poreux sous la forme de nanoparticules.

Un composé précurseur de carbone capable d'être décomposé catalytiquement par les nanoparticules de fer formées à partir des particules de ferrocène est l'acétylène ; la question de savoir si le toluène de l'aérosol catalyseur est également décomposé ou non dépend essentiellement de la température. L'acétylène peut être le gaz vecteur de l'aérosol catalyseur.

On peut utiliser d'autres molécules comme précurseur de catalyseur, par exemple le cobaltocène, le nickelocène, ou un mélange de ferrocène et/ou cobaltocène et/ou nickelocène.

### 2. Le substrat poreux

Ledit précurseur de catalyseur, de préférence l'aérosol catalyseur, est véhiculé par un gaz vecteur et constitue le premier flux gazeux ; ce flux est mis en contact avec un substrat poreux. C'est une deuxième caractéristique essentielle du procédé selon l'invention. Le substrat doit présenter les caractéristiques suivantes : une bonne tenue à haute température, une porosité ouverte aux gaz réactifs, une bonne inertie chimique vis-à-vis des réactifs, une bonne affinité chimique de surface avec le catalyseur (pour assurer une adhésion qui promeut le régime de croissance de nanotubes ou nanofibres de carbone par leur base, ce mécanisme de croissance étant connu sous le terme « base growth mechanism », discuté ci-dessus), et une faible solubilité du catalyseur en volume pour limiter la diffusion et désactivation de la particule catalytique.

Le substrat poreux doit présenter en particulier une porosité ouverte suffisante pour pouvoir être traversé par un flux gazeux. Ledit substrat poreux peut être une membrane poreuse.

Les substrats suivants conviennent en particulier, à condition de présenter des pores interconnectées (par opposition aux porosités fermées) :
- le silicium poreux (qui peut être obtenu par gravure chimique de silicium monocristallin à l'aide d'un masque microlithographique approprié ; on obtient ainsi une membrane présentant des pores traversants d'un diamètre de l'ordre du micromètre (typiquement entre 0,7 µm et 3 µm, appelé « silicium macroporeux ») ; si la nature chimique du silicium ne convient pas on peut déposer une couche mince d'un autre matériau, par exemple par électrodéposition) ;
- l'alumine poreuse (qui peut être obtenue par anodisation d'une tôle d'aluminium puis détachement de la couche d'oxyde de son substrat ; la couche anodique présente des pores colonnaires, parallèles entre elles et perpendiculaires par rapport au substrat, d'un diamètre qui se situe typiquement entre 10 nm et 100 nm) ;
- le carbure de silicium poreux, notamment le carbure de silicium β et de préférence sous la forme de mousse ;
- les mousses métalliques (par exemple les mousses d'aluminium) ;
- les mousses de carbone ;
- les VACNT (soit auto-portés soit déposés sur un substrat poreux ; soit creux soit dont le canal central est remplis de métal ou carbure métallique) ;
- des substrats mixtes (par exemple une mousse de nickel supportée par une membrane d'alumine).

Comme il sera expliqué plus en détail ci-dessous, les substrats non-métalliques qui ne conduisent pas l'électricité peuvent être revêtus au moins partiellement (et de préférence dans la zone proche de leur surface de sortie) d'un film métallique pour renforcer l'effet du chauffage localisé par induction.

La mise en contact du catalyseur ou précurseur de catalyseur avec le substrat poreux peut se faire de plusieurs manières.

Dans un premier mode de réalisation le premier flux gazeux (comprenant le composé précurseur de catalyseur avec son gaz vecteur) est injecté dans ledit substrat poreux qu'il traverse au moins en partie. Dans un deuxième mode de réalisation il est injecté à proximité dudit substrat poreux, notamment à proximité de sa surface externe, par l'extérieur.

On préfère que ledit premier flux gazeux soit injecté dans le substrat poreux. Alternativement II peut être injecté dans le réacteur à proximité du substrat, notamment sur sa surface externe.

Le procédé selon l'invention présente la particularité d'approvisionner simultanément tout au long de la croissance des nanotubes le milieu réactionnel en nanoparticules catalytiques et en précurseur carboné. Dans les procédés selon l'état de la technique, l'apport du catalyseur et l'approvisionnement en précurseur carboné sont habituellement séparés en deux étapes distinctes : dans une première étape on dépose des particules catalytiques sur le substrat ou dans le substrat, puis dans une deuxième étape on fait croître les nanotubes de carbone par apport de précurseur carboné.

Les inventeurs ont découvert que le procédé selon l'invention permet de s'affranchir de la limitation de la longueur des CNT par disparition du catalyseur ou perte de son activité catalytique : ce procédé permet de remplacer en permanence le catalyseur devenu inactif ou ayant disparu par désagrégation (c'est-à-dire progressivement entraîné dans le corps des nanotubes au cours de leur croissance). En effet, le procédé selon l'invention conduit à des nanotubes de carbone qui contiennent, espacées mais présentes sur toute la longueur des tubes, des nanoparticules de catalyseur métallique (par exemple : le fer) emprisonnés dans le canal central du nanotube au cours de sa croissance : c'est la signature de ce procédé, découlant de l'apport permanent de catalyseur sous la forme d'un aérosol, qu'il partage avec le procédé décrit dans EP 1 515 911 B1 (voir la figure III-5 (a) de la thèse, citée ci-dessus, de Sebastien Lagoutte, pages 117/118) qui prouve l'apport permanent de catalyseur et sa disparition progressive par incorporation dans les nanotubes.

Sans vouloir être liés par cette théorie, les inventeurs pensent que le procédé selon l'invention résout un problème de mécanisme réactionnel qui limite le potentiel des procédés selon l'état de la technique : lorsque la longueur des VACNT devient supérieure à une certaine limite (typiquement quelques centaines de micromètres ou quelques millimètres) la faible diffusion des précurseurs et des sous-produits (dont les flux s'opposent) bloque l'accès des précurseurs aux sites catalytiques et l'accès des sous-produits à la surface du tapis de VACNT. Dans le procédé selon l'invention le catalyseur se renouvèle régulièrement, et l'accès des gaz réactifs est spatialement séparé du dégagement des sous-produits.

Selon un mode de réalisation particulier, on utilise comme substrat poreux un tapis de VACNT ; dans une variante on utilise un tapis de VACNT dont le canal central comporte des particules métalliques (par exemple Fe ou Ni ou Co) ou de carbure métallique (par exemple carbure de Fe, de Ni ou de Co) provenant du catalyseur fabriqué avec un apport continu de catalyseur par injection périodique d'un aérosol catalyseur, sachant que les particules métalliques ou de carbure qui se trouvent comme inclusions dans le canal central des nanotubes permettent de chauffer ce substrat de manière localisée par induction.

### 3. Le chauffage localisé

Une troisième caractéristique essentielle est que le dépôt chimique en phase vapeur se fait dans une zone localisée du substrat poreux, qui se situe de préférence en sa périphérie aval (par rapport à la direction du flux de gaz vecteur). La localisation de cette zone peut être définie par l'effet d'un chauffage localisé à une température dite T3. C'est dans la zone chauffée que le précurseur de catalyseur se décompose pour former des nanoparticules de catalyseur, et c'est dans cette zone où aura lieu la décomposition catalytique du précurseur de carbone. En fonction de la valeur de la température T3 la décomposition du précurseur de catalyseur peut commencer en amont de cette zone.

Si le premier flux gazeux ne comporte pas de composé précurseur de carbone, ou si on veut apporter un autre composé précurseur de carbone (ou une quantité supplémentaire dudit composé), un deuxième flux gazeux comportant le composé précurseur de carbone doit être injecté aussi proche que possible de cette zone localisée, et de préférence dans cette zone localisée. L'injection dudit deuxième flux gazeux à contre-courant dudit premier flux gazeux est à éviter car elle ne permet pas aux produits réactionnels secondaires de s'évacuer aisément.

Le confinement de la zone de décomposition catalytique du composé précurseur de carbone est un aspect essentiel du procédé selon l'invention. Ce confinement peut être réalisé par deux moyens, qui peuvent être combinés : par le chauffage localisé du substrat poreux à une température au moins égale à T3, et par l'injection localisée du flux de composé précurseur de carbone sur ou dans le substrat (ou une zone dudit substrat) se trouvant à une température au moins égale à T3. Dans les deux modes de réalisation ce confinement définit la zone de catalyse hétérogène à partir de laquelle se fait la croissance continue des nanotubes ou nanofibres de carbone, par leur base.

Dans un premier mode de réalisation c'est la localisation de l'apport énergétique qui définit la zone de catalyse hétérogène. On peut utiliser plusieurs moyens de chauffage localisé. On peut par exemple chauffer sélectivement certaines pièces de la zone réactionnelle et/ou le substrat poreux peut participer au chauffage (en devenant lui-même une pièce chauffée). Cela peut être réalisé par exemple par chauffage inductif, à l'aide d'une bobine qui entoure au moins en partie le substrat et en choisissant judicieusement les matériaux qui constituent l'environnement de la zone réactionnelle. C'est le mode de réalisation préféré.

Dans le chauffage par induction, la zone à chauffer baigne dans le champ magnétique oscillant généré par une bobine qui entoure ladite zone. Dans un mode de réalisation on positionne une pièce métallique au voisinage de la zone de réaction (par exemple proche de la surface de sortie du substrat poreux), toutes les autres pièces situées dans la zone d'influence du champ magnétique appliqué étant soit non métalliques soit en un matériau conducteur électrique présentant une résistivité plus faible que ladite pièce métallique. A titre d'exemple, le substrat poreux peut être en un matériau non métallique (par exemple en alumine poreuse), et une mousse métallique présentant des macropores ouverts peut être apposée sur la surface de sortie du substrat poreux non métallique (ou positionné très proche de cette surface de sortie). Cela est illustré de manière schématique sur la figure 3(a), où le repère **31** désigne ledit substrat poreux non métallique et le repère **32** ladite mousse métallique. Comme illustré sur la figure 3(b) on peut également utiliser un anneau métallique **33** à la place de la mousse métallique, ou en plus de la mousse métallique (variante non montrée sur les figures).

L'apport énergétique localisé peut également se faire par tout moyen approprié, et notamment par chauffage résistif (effet Joule) d'une résistance ou du substrat poreux lui-même, même si ces solutions ne sont pas les solutions préférées (le confinement du chauffage est plus difficile à contrôler, et la connectique devient difficile à gérer). L'apport énergétique peut également se faire par irradiation laser, mais ce n'est pas non plus la solution préférée (car le coefficient d'absorption des surfaces peut évoluer au cours de la synthèse à cause du dépôt de surface, et parce que des contraintes d'encombrement pour le chemin optique du faisceau laser sont à prendre en considération).

Le substrat poreux peut aussi être constitué de nanotubes de carbone, préférablement alignés. Lorsque le substrat poreux est constitué de VACNT, l'apport énergétique localisé peut également se faire par chauffage inductif des VACNT dont le canal central peut éventuellement et avantageusement comporter des particules métalliques ou des carbures d'un métal, comme cela a été expliqué ci-dessus.

L'apport énergétique localisé peut également se faire, au moins en partie, par chauffage inductif directement des particules catalytiques actives pour la synthèse des nanotubes de carbone. Cette solution est celle qui permet le chauffage le plus localisé. Elle peut être utilisée seule, ou de préférence en complément d'un autre moyen de chauffage, en particulier dans le cas où elle ne permet pas seule de constituer la totalité de l'apport énergétique nécessaire à la croissance des CNT.

A ces moyens de chauffage localisé peuvent s'ajouter un préchauffage desdits premier et/ou deuxième flux gazeux.

Le substrat poreux (non-métallique et isolant) peut aussi être pourvu d'un revêtement métallique pour que seule sa surface soit chauffée par induction (par exemple un revêtement d'aluminium sur une alumine poreuse).

Le confinement de l'apport énergétique pourra également être complété par l'insertion de barrières thermiques, par exemple constituée de couches à faible conductivité thermique proche de la zone réactive (surface de sortie du substrat poreux).

### 4. Le réacteur

Le substrat chauffé se trouve dans une enceinte, appelé ici « réacteur », et le procédé a avantageusement lieu à une pression proche de la pression atmosphérique. Cette enceinte peut être fermée ou partiellement fermée mais rendue étanche aux échanges gazeux entre l'intérieur et l'extérieur du réacteur. Elle comporte des moyens pour recueillir les nanotubes formés. L'enceinte peut comporter des moyens pour chauffer ses parois, afin d'éviter des gradients thermiques trop importants au sein du réacteur. Le réacteur comporte également des moyens de pompage, sachant que les gaz entrant dans réacteur ainsi que les gaz résultant du procédé doivent être évacués en continu. Le réacteur comporte également des moyens de purge; la purge peut se faire par un rinçage à l'aide d'un gaz neutre, associé ou non à un étuvage du réacteur préalablement au démarrage du procédé.

La figure 4 montre de manière schématique trois vues partielles en section transversale de réacteurs qui conviennent pour la mise en oeuvre du procédé selon l'invention. La figure 4(a) montre le conduit d'alimentation **41** en mélange gazeux **40** (ce mélange gazeux comprenant le précurseur de catalyseur et le précurseur de carbone) avec les moyens de chauffage **42** permettant d'atteindre une température T2 (définie ci-dessus, par exemple une résistance chauffante entourant le conduit d'alimentation), ainsi que le substrat poreux **43** traversé par ce flux gazeux. Les moyens de chauffage localisé **45** (par exemple un anneau métallique chauffé par une bobine d'induction) permettant d'atteindre une température T3 suffisante pour permettre la croissance catalytique de nanotubes ou nanofibres de carbone se situent très proches de la surface de sortie **44** du substrat poreux **43.** En aval du substrat poreux **43** se situe, de manière optionnelle, une zone de chauffage pourvue de moyens de chauffage permettant de chauffer les nanotubes ou nanofibres à une température T4 permettant d'améliorer leur cristallinité. La condition T2 < T3 doit être remplie.

La figure 4(b) montre la croissance des nanotubes ou nanofibres de carbone **46** qui se déploient dans une zone tubulaire de déploiement **49** située en aval du substrat poreux **43.** Si le réacteur comprend les moyens de chauffage permettant de chauffer les nanotubes ou nanofibres à une température T4, ces moyens se situent avantageusement autour de cette zone tubulaire de déploiement **49.**

La figure 4(c) montre un moyen **47** permettant d'embobiner les nanotubes ou nanofibres. Les gaz réactionnels n'ayant pas réagis, les gaz porteurs et les produits réactionnels gazeux quittent le réacteur par un orifice d'évacuation **48.** La pression est avantageusement proche de la pression ambiante.

### 5. Variantes concernant l'injection des réactifs

Afin de pouvoir confiner précisément la zone réactionnelle, il est souhaitable que le mélange des espèces chimiques gazeuses et/ou des particules de l'aérosol puisse se faire de façon localisée, au plus proche de la zone de catalyse hétérogène (zone réactionnelle) visée, c'est à dire au plus proche de la surface de sortie du substrat poreux. En effet, si la décomposition des molécules du mélange réactionnel a lieu à l'intérieur du substrat poreux et que la température n'est pas suffisamment confinée (typiquement une température supérieure à 450°C), la croissance des CNT aura lieu loin de la surface du substrat poreux, ce qui entraînera inévitablement un bouchage des pores et l'arrêt de la croissance des CNT.

Les inventeurs ont trouvé que l'on peut utiliser des têtes d'injection coaxiales, tel qu'elles sont utilisées dans le domaine de la synthèse de fibres par électro-spinning : ces têtes d'injection coaxiale permettent en particulier de confiner les gaz réactifs sans les mélanger à une échelle de quelques millimètres ; la sortie de la tête d'injection peut correspondre à la surface d'entrée du substrat poreux.

Dans ce cas de l'injection séparée (par exemple coaxiale) des deux flux gazeux, deux cas de figures extrêmes se présentent : (i) dans un substrat avec porosité aléatoire, les gaz réactifs vont se mélanger progressivement au cours de la traversée du substrat poreux ; si la température n'est pas suffisamment confinée proche de la surface de sortie du substrat poreux, un bouchage de (certains) pores risque de se produire ; (ii) dans un substrat avec porosité cloisonnée (canaux étanches), les gaz réactifs ne se mélangent qu'à la sortie du substrat poreux, les pores ne se bouchent pas mais la réaction peut ne pas avoir lieu à la surface du substrat si le mélange se fait seulement après avoir traversé complètement le substrat poreux.

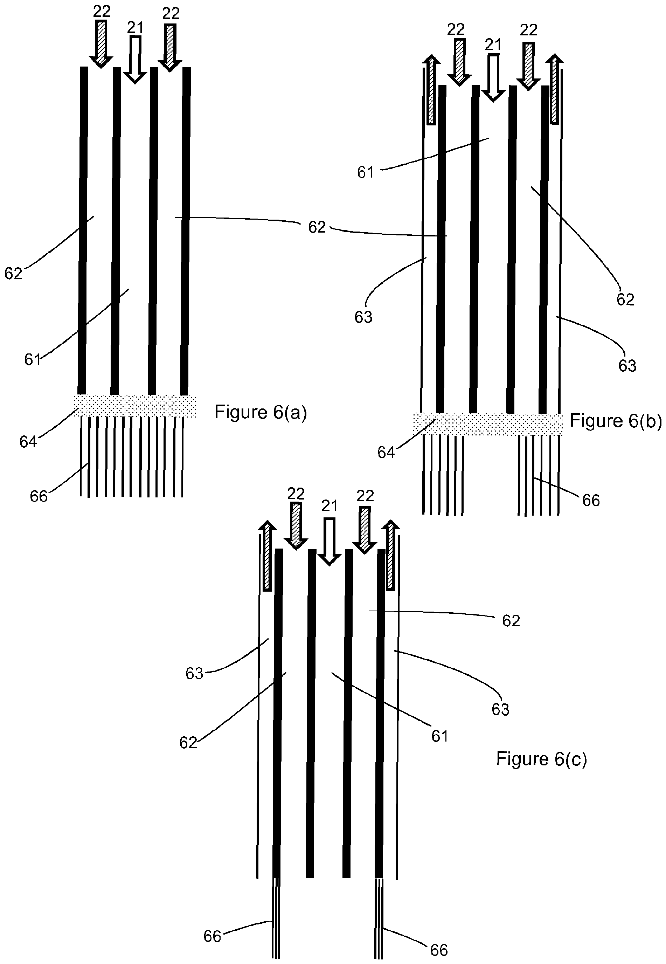

D'autres cas de figure intermédiaires sont envisageables, notamment celui du flux forcé à la surface du substrat poreux : un canal est dédié au pompage (extraction) du mélange réactif), et celui où les gaz réactionnels se mélangent très proche de la surface de sortie mais « au-dessous » celle-ci (injecteur multiple à canaux entremêlés, éventuellement associé à un substrat poreux). Deux de ces modes de réalisation sont illustrés sur la figure 6. La figure 6(a) montre une mode de réalisation avec injection coaxiale (représenté en coupe longitudinale) : un premier flux gazeux **21** est injecté dans le substrat poreux **64** réacteur à travers un premier tube périphérique **61,** au centre duquel se trouve un deuxième tube **62** qui injecte le deuxième flux gazeux **22.** Les deux flux gazeux se mélangent dans le substrat poreux **64,** et la croissance des nanotubes de carbone **66** a lieu à la surface du substrat. La figure 6(a) ne montre pas les moyens pour le chauffage confiné assurant la température T4 nécessaire pour la croissance des nanotubes de carbone.

La figure 6(b) montre un mode d'injection plus complexe dérivé de celui de la figure 6(a) avec un tube extérieur **61** et intérieur **62** coaxiaux et un tube périphérique coaxial **63** dédié à l'aspiration du mélange réactif ; les flux gazeux se mélangent lorsqu'il sont déviés dans le tube d'aspiration **63.** Si on ne prévoit pas de substrat poreux, la croissance des nanotubes de carbone a lieu sur les bords (la tranche) du tube **62** injectant le deuxième flux gazeux **22** ; les tubes coaxiaux jouant dans ce cas le rôle d'un substrat poreux à porosité cloisonnée. Si on prévoit un substrat poreux, la croissance des nanotubes de carbone à lieu sur ou au voisinage de la surface de sortie de celui-ci; dans ce mode de réalisation le substrat poreux est avantageusement très mince (membrane poreuse).

### 6. Caractéristiques générales du procédé, avantages

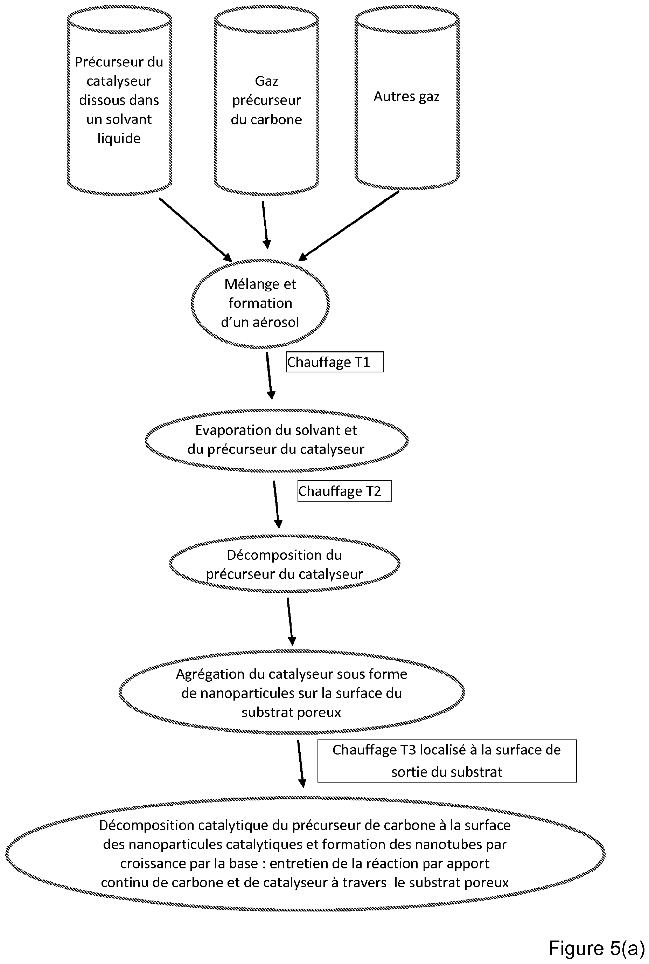

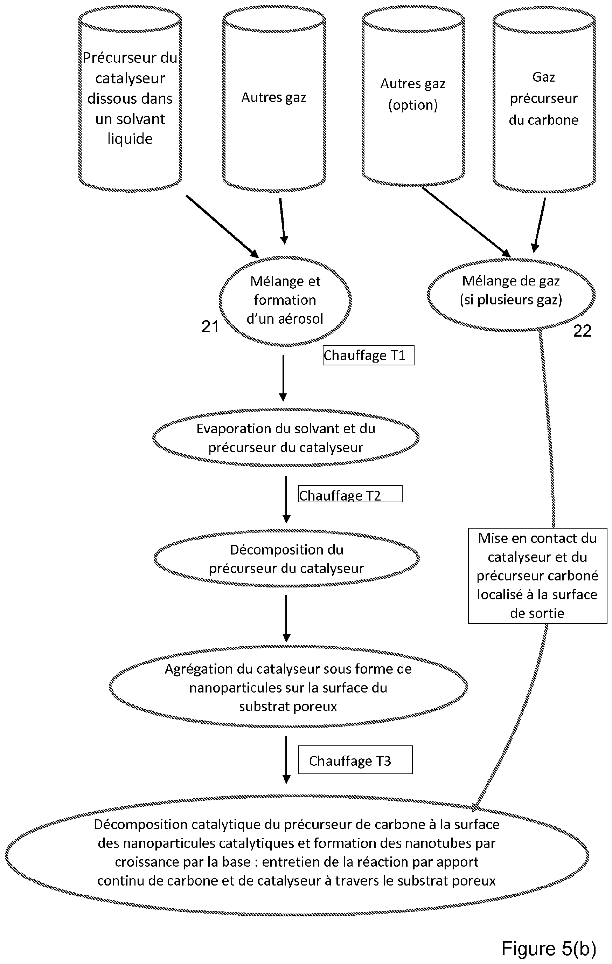

La figure 5 monte de manière schématique deux modes de réalisation du procédé selon l'invention.

La figure 5(a) montre un mode de réalisation avec chauffage localisé à la température de décomposition catalytique du précurseur de carbone, par l'un des moyens présenté ci-dessus en section 3. Le précurseur du catalyseur est dissout dans un solvant liquide. Il peut s'agir par exemple de ferrocène dissout dans le toluène. On forme un aérosol comprenant des particules (gouttelettes) de cette solution et une phase gazeuse comme vecteur, ladite phase gazeuse comprenant le gaz précurseur de carbone, qui est un hydrocarbure, et ladite phase gazeuse pouvant comprendre d'autres gaz. Cet aérosol est chauffé à une première température T1, suffisante pour permettre l'évaporation du solvant et du précurseur de catalyseur. Puis cette phase gazeuse est chauffée à une deuxième température T2, suffisante pour permettre la décomposition du précurseur du catalyseur. Cette décomposition forme probablement des atomes d'un élément de métal approprié, puis des agrégats métalliques. A titre d'exemple, si le précurseur du catalyseur est le ferrocène on forme des atomes de fer. Ces atomes s'agrègent et forment des nanoparticules de métal sur la surface du substrat poreux. (On note que dans le cadre de la présente invention il n'est pas important de savoir si l'agrégation a lieu en phase gazeuse ou sur la surface du substrat). Par le chauffage localisé d'une zone proche de la surface de sortie du substrat à une troisième température T3 suffisante pour permettre la croissance catalytique de nanotubes ou nanofibres de carbone on permet au précurseur de carbone la décomposition catalytique à la surface des nanoparticules catalytiques. Cette décomposition conduit à la formation de nanotubes de carbone par le mécanisme de la croissance par la base, moyennant un apport continu de carbone fraîchement généré par la décomposition du précurseur de carbone, cet apport se faisant à travers le substrat poreux. Des nanoparticules fraîches de catalyseur sont formées quasiment en continu, ou pour le moins périodiquement, par apport continu d'atomes de métal qui s'agglomèrent pour former de nouvelles nanoparticules ou qui viennent s'ajouter aux nanoparticules existantes, cet apport se faisant à travers le substrat poreux. Ainsi la croissance des nanotubes de carbone ne s'interrompt normalement pas, sauf événement accidentel ou instabilité des conditions réactionnelles. Dans ce mode de réalisation la condition T1 < T2 < T3 doit être remplie.

La figure 5(b) monte un autre mode de réalisation avec apport localisé du précurseur de carbone dans la zone réactionnelle chauffée à une température T3 suffisante pour permettre la croissance de nanotubes ou nanofibres de carbone. Un premier flux gazeux **21** est formé par l'aérosol catalytique dans un gaz porteur (qui peut être un gaz source de carbone ou, comme indiqué sur le schéma, un autre gaz). Un deuxième flux gazeux **22** est formé par un précurseur de carbone, possiblement dilué dans un autre gaz. Le précurseur du catalyseur dissous dans le solvant liquide est mélangé avec un autre gaz pour former un aérosol, comme dans le mode de réalisation de la figure 5(a), qui est chauffé à une première température T1 pour évaporer le solvant et le précurseur de catalyseur. Ce flux gazeux est chauffé à une deuxième température T2, suffisante pour permettre la décomposition du précurseur du catalyseur ; les atomes de métal dudit précurseur du catalyseur s'agrègent et forment des nanoparticules de métal sur la surface du substrat poreux. Comme dans le mode de réalisation précédent, le substrat est chauffé à une troisième température T3 suffisante pour permettre la croissance de nanotubes ou nanofibres de carbone. Le deuxième flux gazeux **22** qui comporte un gaz précurseur de carbone, possiblement mélangé avec un autre gaz, est mis en contact avec le catalyseur localisé à la surface de sortie du substrat poreux par apport localisé dans la zone chauffée à ladite troisième température T3, de manière à ce que la décomposition catalytique dudit précurseur de carbone dans cette zone conduise à la formation de nanotubes de carbone par le mécanisme de la croissance par la base, moyennant un apport continu de carbone fraîchement généré par la décomposition du précurseur de carbone, cet apport se faisant de manière localisé. Des nanoparticules fraîches de catalyseur sont formées quasiment en continu, ou pour le moins périodiquement, par apport continu d'atomes de métal qui s'agglomèrent pour former de nouvelles nanoparticules ou qui viennent s'ajouter aux nanoparticules existantes, cet apport se faisant à travers le substrat poreux. Ainsi la croissance des nanotubes de carbone ne s'interrompt normalement pas, sauf événement accidentel ou instabilité des conditions réactionnelles. Dans ce mode de réalisation aussi la condition T1 < T2 < T3 doit être remplie.

Dans les deux modes de réalisation qui viennent d'être décrit, i.e. avec chauffage localisé à la température T3 ou avec apport localisé du précurseur de carbone dans la zone chauffée à la température T3, une quatrième zone de chauffage à une quatrième température T4 peut être prévue en aval de la zone de croissance des nanotubes, pour améliorer la cristallinité (i.e. l'ordre à l'échelle atomique et nanométrique) des nanotubes ou nanofibres de carbone formés.

Sans vouloir être liés par cette théorie, les inventeurs pensent que le procédé selon l'invention permet de former in situ (i.e. sur la surface poreuse du substrat, et dans la zone réactionnelle) des particules catalytiques à partir des particules de l'aérosol catalyseur ; en effet, ces particules de composé précurseur d'un catalyseur se décomposent par pyrolyse dans la zone localisée chauffée du substrat poreux, et forment des particules métalliques de taille nanométriques. Dans cette même zone réactionnelle le composant précurseur de carbone acheminé, soit sous forme gazeuse soit sous la forme de particules liquides, avec le gaz vecteur ou injecté indépendamment, se décompose sous l'effet catalytique des particules de catalyseur.

Le procédé selon l'invention serait donc caractérisé par le fait que l'approvisionnement en réactifs est localisé directement au voisinage des particules catalytiques, et dans la zone réactionnelle. A cette fin on utilise un substrat poreux qui peut jouer à la fois le rôle de support mécanique, de régénérateur de catalyseur et de source de précurseur carboné. Dans cette configuration préféré le flux de gaz réactifs (catalyseur et précurseur carboné) n'est plus opposé au flux de sous-produits et un régime permanent d'approvisionnement - évacuation peut s'établir, indépendant de la longueur des nanotubes de carbone. Cette configuration est compatible avec une croissance de CNT qui perdure tant que les conditions d'approvisionnement en réactifs et d'évacuation des sous-produits sont maintenues de manière stable, c'est-à-dire de façon quasi-infinie.

Le procédé selon l'invention permet la croissance de nanotubes et nanofibres de grande longueur, cette croissance se faisant sous la forme d'un faisceau de nanotubes ou nanofibres parallèles ; cela facilite la manipulation de nanotubes ou nanofibres obtenus. A titre d'exemple, au cours de leur croissance on peut les conduire dans un tube en dirigeant le flux de gaz sortant de la zone réactionnelle vers ce tube. A titre d'exemple, ce tube peut être en métal ou en quartz, et son extrémité peut se situer à proximité du substrat (qui peut être une surface de collecte, par exemple la surface d'un rouleau en rotation), ce qui permet d'accueillir, de diriger et de protéger le faisceau de nanotubes ou nanofibres obtenus.

Ces nanotubes et nanofibres montrent un nombre très faible d'interfaces ou de jonction cristallines sur leur longueur, ou sont même exempts de telles interfaces ou jonctions ; ces interfaces et jonctions peuvent être mises en évidence par différentes techniques d'analyse connues de l'homme du métier, et en tout état de cause par microscopie électronique à transmission.

## Revendications

1. Procédé de préparation de nanotubes, nanofibres ou nanofilaments de carbone par décomposition d'au moins un précurseur de carbone en présence d'un catalyseur, dans lequel procédé, de manière continue :
- un premier flux gazeux (21) comprenant un précurseur d'un catalyseur est mis en contact avec un substrat poreux (43, 64) ;
- un deuxième flux gazeux (22) comportant au moins un précurseur de carbone est mis en contact avec ledit substrat poreux (43, 64), sachant que ledit premier flux gazeux et ledit deuxième flux gazeux peuvent être représentés par le même flux de mélange gazeux ;
- ledit substrat poreux (43, 64) est chauffé à une température conduisant au dépôt de particules de catalyseur et à la croissance catalytique de nanotubes de carbone,
et dans lequel procédé ledit premier flux gazeux et, si présent, ledit deuxième flux gazeux sont apportés à proximité dudit substrat poreux.

2. Procédé selon la revendication 1, dans lequel ledit substrat est traversé au moins en partie par ledit premier flux gazeux (21).

3. Procédé selon la revendication 1, dans lequel ledit premier flux gazeux (21) est dirigé sur une zone de surface dudit substrat poreux (43, 64).

4. Procédé selon l'une quelconque des revendications 1 à 3, dans lequel ledit premier flux gazeux et ledit deuxième flux gazeux sont représentés par le même flux de mélange gazeux.

5. Procédé selon l'une quelconque des revendications 2 à 4, dans lequel ledit substrat poreux (43, 64) est chauffé de manière localisée dans la zone par laquelle ledit premier flux gazeux (21) quitte le substrat (43, 64), ou dans la zone sur laquelle est dirigé ledit premier flux gazeux (21).

6. Procédé selon la revendication 5, dans lequel ledit chauffage localisé se fait par induction électromagnétique.

7. Procédé selon la revendication 6, dans lequel ledit chauffage localisé se fait, au moins en partie, par chauffage inductif des particules de catalyseur.

8. Procédé selon l'une quelconque des revendications 1 à 7, dans lequel ledit précurseur de carbone est un hydrocarbure, et de préférence de l'acétylène, et/ou du monoxyde de carbone.

9. Procédé selon l'une quelconque des revendications 1 à 8, dans lequel ledit premier flux gazeux est généré à partir d'un aérosol comportant un composé métallo-organique dans un gaz vecteur.

10. Procédé selon la revendication 9, dans lequel ledit composé métallo-organique est sélectionné dans le groupe formé par le ferrocène, le cobaltocène, le nickélocène.

11. Procédé selon l'une quelconque des revendications 1 à 10, dans lequel ledit substrat poreux (43, 64) est une membrane poreuse.

12. Réacteur pour la mise en oeuvre du procédé selon l'une quelconque des revendications 1 à 11, comportant, dans le sens de l'écoulement du flux de gaz :
o une zone d'injection d'un flux de gaz réactif pourvue de premiers moyens de chauffage (42) aptes à chauffer les gaz à une température T2 comprise entre 250 °C et 450 °C,
o un substrat poreux (43) parcouru par ledit flux de gaz réactif,
o une zone pourvue de deuxièmes moyens de chauffage (45) aptes à chauffer au moins une partie dudit substrat poreux (43) à une température T3 comprise entre 450 °C et 700 °C, lesdits moyens de chauffage étant des moyens de chauffage localisé,
o une zone tubulaire de déploiement (49) apte à permettre le déploiement des nanofibres ou nanotubes formées,
∘ optionellement, des moyens (47) pour recueillir lesdites nanofibres ou nanotubes ;
o une sortie (48) par laquelle les gaz peuvent quitter ledit réacteur,
et **caractérisé en ce qu'**il comprend des moyens de confinement de la zone de décomposition catalytique du précurseur de carbone, et **en ce qu'**il comprend, de préférence dans ladite zone de déploiement (49), des troisièmes moyens de chauffage aptes à chauffer les nanotubes ou nanofibres formées à une température T4 comprise entre 800 °C et 2 000 °C.

13. Réacteur selon la revendication 12, **caractérisé en ce qu'**il comprend des moyens d'approvisionnement d'un premier flux de gaz réactif comprenant un précurseur d'un catalyseur et d'un deuxième flux de gaz réactif comprenant au moins un précurseur de carbone.

14. Réacteur selon l'une quelconque des revendications 12 à 13, **caractérisé en ce que** lesdits moyens de chauffage localisé agissent comme des moyens de confinement de la zone de décomposition catalytique du précurseur de carbone.

## Patentansprüche

1. Verfahren zur Herstellung von Kohlenstoffnanoröhren, - nanofasern oder -nanofilamenten durch Zersetzung mindestens eines Kohlenstoffvorläufers in Gegenwart eines Katalysators, bei dem kontinuierlich:
- ein erster Gasstrom (21), der eine Vorstufe eines Katalysators umfasst, mit einem porösen Substrat (43, 64) in Kontakt gebracht wird;
- ein zweiter Gasstrom (22), der mindestens einen Kohlenstoffvorläufer umfasst, mit diesem porösen Substrat (43, 64) in Kontakt gebracht wird, wobei dieser erste Gasstrom und dieser zweite Gasstrom durch denselben Gasgemischstrom dargestellt werden können;
- das poröse Substrat (43, 64) auf eine Temperatur erhitzt wird, die zur Ablagerung von Katalysatorpartikeln und zum katalytischen Wachstum von Kohlenstoffnanoröhren führt,
und bei welchem Verfahren dieser erste Gasstrom und, wenn vorhanden, dieser zweite Gasstrom in die Nähe dieses porösen Substrates gebracht wird.

2. Verfahren nach Anspruch 1, bei dem dieses Substrat zumindest teilweise von dem ersten Gasstrom (21) durchquert wird.

3. Verfahren nach Anspruch 1, bei dem dieser erste Gasstrom auf einen Oberflächenbereich dieses porösen Substrats (43,64) gerichtet wird.

4. Verfahren nach einem der Ansprüche 1 bis 3, bei dem dieser erste Gasstrom und dieser zweite Gasstrom durch denselben Gasgemischstrom dargestellt werden.

5. Verfahren nach einem der Ansprüche 2 bis 4, bei dem dieses poröse Substrat (43, 64) lokal in der Zone erhitzt wird, durch die dieser erste Gasstrom (21) das Substrat (43, 64) verlässt, oder in der Zone, auf welche dieser erste Gasstrom (21) gerichtet ist.

6. Verfahren nach Anspruch 5, bei dem die örtliche Erwärmung durch elektromagnetische Induktion erfolgt.

7. Verfahren nach Anspruch 6, bei dem diese örtliche Erwärmung zumindest teilweise durch induktives Erhitzen der Katalysatorpartikel erreicht wird.

8. Verfahren nach einem der Ansprüche 1 bis 7, bei dem dieser Kohlenstoffvorläufer ein Kohlenwasserstoff und vorzugsweise Acetylen und/oder Kohlenmonoxid ist.

9. Verfahren nach einem der Ansprüche 1 bis 8, bei dem dieser erste Gasstrom aus einem Aerosol erzeugt wird, das eine metallorganische Verbindung in einem Trägergas umfasst.

10. Verfahren nach Anspruch 9, bei dem diese metallorganische Verbindung ausgewählt wird aus der Gruppe, die durch Ferrocene, Cobaltocene und Nickelocene gebildet wird.

11. Verfahren nach einem der Ansprüche 1 bis 10, bei dem dieses poröse Substrat (43, 64) eine poröse Membran ist.

12. Reaktor zur Durchführung des Verfahrens nach einem der Ansprüche 1 bis 11, umfassend, in Strömungsrichtung des Gasstroms:
- eine Zone zum Einspritzen eines reaktiven Gasstroms, die mit ersten Heizmitteln (42) ausgestattet ist, die in der Lage sind, die Gase auf eine Temperatur T2 zwischen 250 °C und 450 °C zu erhitzen,
- ein poröses Substrat (43), das von dem reaktiven Gasstrom durchströmt wird,
- eine Zone, die mit zweiten Heizmitteln (45) ausgestattet ist, die in der Lage sind, zumindest einen Teil des porösen Substrats (43) auf eine Temperatur T3 zwischen 450°C und 700°C zu erhitzen,
- eine röhrenförmige Entfaltungszone (49), die in der Lage ist, die Entfaltung der gebildeten Nanofasern oder Nanoröhren zu ermöglichen,
- optional Mittel (47) zum Sammeln dieser Nanofasern oder Nanoröhren;
- einen Auslass (48), durch den die Gase den Reaktor verlassen können,
• und **dadurch gekennzeichnet, dass** er Mittel zum Eingrenzen der katalytischen Zersetzungszone des Kohlenstoffvorläufers umfasst, und dass er, vorzugsweise in der Einsatzzone (49), dritte Heizmittel, umfasst, die in der Lage sind, die gebildeten Nanoröhren oder Nanofasern auf eine Temperatur T4 zwischen 800 °C und 2.000 °C zu erhitzen.

13. Reaktor nach Anspruch 12, **dadurch gekennzeichnet, dass** er Mittel zum Zuführen eines ersten Stroms reaktiven Gases, der einen Vorläufer eines Katalysators umfasst, und eines zweiten Flusses reaktiven Gases, der mindestens einen Vorläufer von Kohlenstoff umfasst, umfasst.

14. Reaktor nach einem der Ansprüche 12 bis 13, **dadurch gekennzeichnet, dass** die örtlichen Heizmittel als Eingrenzungsmittel für die katalytische Zersetzungszone des Kohlenstoffvorläufers dienen.

## Claims

1. Method for preparing carbon nanotubes, nanofibers or nanofilaments by decomposition of at least one carbon precursor in the presence of a catalyst, in which method continuously:
- a first gas stream (21) comprising a precursor of a catalyst is brought into contact with a porous substrate (43, 64);
- a second gas stream (22) including at least one carbon precursor is brought into contact with said porous substrate (43, 64), knowing that said first gas stream and said second gas stream may be represented by the same gas stream mixture;
- said porous substrate (43, 64) is heated to a temperature leading to the deposition of catalyst particles and to the catalytic growth of carbon nanotubes,
• and in which method said first gas stream and, if present, said second gas stream are supplied in vicinity of said porous substrate.

2. Method according to claim 1, wherein said substrate is passed through at least partially by said first gas stream (21).

3. Method according to claim 1, wherein said first gas stream (21) is directed on a surface zone of said porous substrate (43, 64) .

4. Method according to any of claims 1 to 3, wherein said first gas stream and said second gas stream are represented by the same gas stream mixture.

5. Method according to any of claims 2 to 4, wherein said porous substrate (43, 64) is heated locally in the zone through which said first gas stream (21) leaves the substrate (43, 64), or in the zone on which is directed said first gas stream (21).

6. Method according to claim 5, wherein said localized heating is carried out by electromagnetic induction.

7. Method according to claim 6, wherein said localized heating is carried out, at least partially, by inductive heating of the catalyst particles.

8. Method according to any of claims 1 to 7, wherein said carbon precursor is a hydrocarbon, and preferably acetylene, and/or carbon monoxide.

9. Method according to any of claims 1 to 8, wherein said first gas stream is generated from an aerosol including a metallo-organic compound in a carrier gas.

10. Method according to claim 9, wherein said metallo-organic compound is selected from the group formed by ferrocene, cobaltocene, nickelocene.

11. Method according to any of claims 1 to 10, wherein said porous substrate (43, 64) is a porous membrane.

12. Reactor for implementing the method according to any of claims 1 to 11, including, following the direction of the flow of the gas stream:
o a zone for injecting a stream of reactant gas provided with first means of heating (42) capable of heating the gases to a temperature T2 between 250°C and 450°C,
o a porous substrate (43) travelled through by said stream of reactant gas,
o a zone provided with second means of heating (45) capable of heating at least one portion of said porous substrate (43) to a temperature T3 between 450°C and 700°C,
o a tubular deployment zone (49) capable of allowing for the deployment of the nanofibers or nanotubes formed,
o optionally, means (47) for collecting said nanofibers or nanotubes;
o an outlet (48) through which the gases can exit said reactor, and **characterized in that** it comprises means for confining the catalytic decomposition zone of the carbon precursor, and **in that** it comprises, preferably in said deployment zone (49), third means of heating capable of heating the nanotubes or nanofibers formed to a temperature T4 between 800°C and 2,000°C.

13. Reactor according to claim 12, **characterized in that** it comprises means for supplying a first stream of reactant gas comprising a precursor of a catalyst and a second stream of reactant gas comprising at least one carbon precursor.

14. Reactor according to any of claims 12 to 13, **characterized in that** said means of localized heating act as means for confining the catalytic decomposition zone of the carbon precursor.
